# DEMANDE DE BREVET EUROPEEN

(11) **EP 0 996 165 A1**
(43) Date de publication de la demande: **26.04.2000**
(21) Numéro de dépôt: 99410140.0
(22) Date de dépôt: 19.10.1999
(51) Int. Cl.: H01L 29/06

(54) **Composant de puissance portant des interconnexions**

(30) Priorité: 19.10.1998 FR 9813219
(71) Demandeur: STMicroelectronics S.A., 94250 Gentilly (FR)
(72) Inventeur: Roy, Mathieu, 37300 Joue les Tours (FR)
(74) Mandataire: de Beaumont, Michel

(57) **Abrégé**

L'invention concerne un composant de puissance formé dans un substrat de silicium (1) de type N délimitée par un mur (2) de type P, ayant une face inférieure comprenant une première région (3) de type P reliée au mur (2), et une face supérieure comprenant une deuxième région (4) de type P, une piste conductrice (L) s'étendant au-dessus du substrat entre la deuxième région (4) et le mur (2). Le composant comprend une troisième région (22) de type N à fort niveau de dopage formée dans le substrat sous une portion de la piste sensiblement à ni-chemin entre la périphérie externe de la deuxième région et la périphérie interne du mur. Cette troisième région est contactée par une plaque de champ (21), s'étendant de part et d'autre de la troisième région en direction du mur et de la deuxième région.

## Description

La présente invention concerne les composants de puissance verticaux et plus particulièrement une optimisation de la tenue en tension de composants de puissance dont la face supérieure porte des connexions.

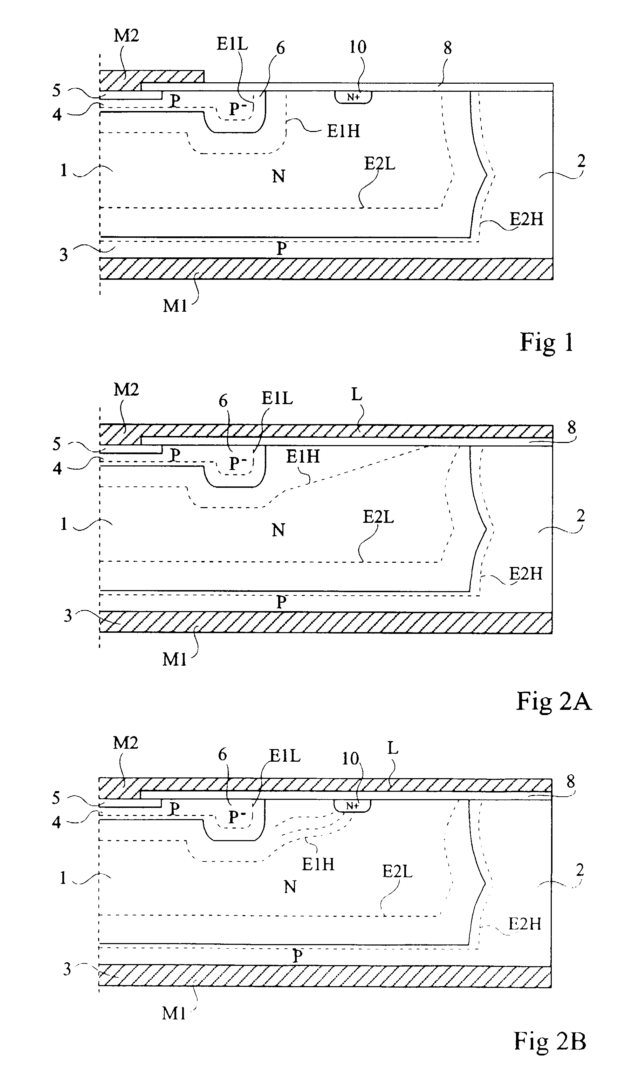

La figure 1 représente de façon très schématique une vue en coupe partielle d'une portion d'un composant de puissance haute tension dans une région frontalière de celui-ci. Le composant, dont une partie seulement est illustrée, est formé dans un substrat de silicium faiblement dopé 1. Dans toute la suite de la présente description, on considérera que ce substrat est de type N mais bien entendu tous les types de conductivité pourraient être inversés. Le composant est délimité à sa périphérie par un mur d'isolement 2 qui s'étend de la face supérieure à la face inférieure du substrat. Le mur d'isolement peut correspondre à la limite de la puce semiconductrice dans laquelle est formé le composant 1. Il peut aussi correspondre, à l'intérieur d'une puce semiconductrice, à une séparation entre deux composants voisins. Bien entendu, la présente invention s'applique aussi à des composants de type silicium sur isolant (SOI).

Dans une configuration courante de composants semiconducteurs verticaux haute tension, une couche 3 de type P est formée de façon continue ou non sur la face inférieure du substrat et s'étend jusqu'au mur d'isolement. Du côté de la face supérieure du substrat, on trouve une couche 4 également de type P. La couche 4 de type P, le substrat 1 de type N et la couche 3 de type P sont des couches constitutives d'un composant vertical haute tension, la haute tension pouvant être supportée notamment du fait de la forte épaisseur et du faible niveau de dopage du substrat 1. L'ensemble des couches PNP 4-1-3 pourra par exemple constituer un transistor.

Une métallisation de face arrière M1 est en contact avec l'ensemble de la face arrière du composant et une métallisation M2 est liée, directement ou indirectement, à la couche 4. Cette liaison est directe dans le cas où l'on cherche à faire un transistor PNP. Dans le cas représenté, où l'on cherche à faire un thyristor avec ou sans gâchette, une couche supplémentaire 5 fortement dopée de type N est réalisée pour constituer la cathode du thyristor en contact avec la métallisation M2. La périphérie de la couche 4 est espacée du mur d'isolement 2 par une portion du substrat 1 et en outre comporte de préférence une zone 6 de type P faiblement dopée (P⁻) plus profonde que la région 4.

Lorsqu'une tension positive est appliquée entre les métallisations M1 et M2, la jonction bloquante est la jonction entre le substrat 1 et la région P 4-6. Autour de cette jonction, la tenue en tension est assurée par une zone dite de charge d'espace délimitée par des équipotentielles E1L et E1H, représentées en pointillés dans la figure. L'équipotentielle E1L indique la zone au potentiel bas de l'électrode M2, par exemple 0 volt. L'équipotentielle E1H désigne la zone au potentiel haut de l'électrode M1, par exemple 600 volts.

Quand le dispositif est polarisé en inverse, c'est-à-dire que la métallisation M2 est polarisée positivement par rapport à la métallisation M1, la tenue en tension est essentiellement assurée par la jonction entre le substrat 1 et d'une part la couche P 3, d'autre part le mur d'isolement 2. On a désigné par E2L et E2H les limites de la zone de charge d'espace, c'est-à-dire les équipotentielles au potentiel bas et au potentiel haut, respectivement. Pour qu'un dispositif ait une tenue en tension élevée, il convient que les équipotentielles extrêmes soient aussi écartées que possible pour ne pas atteindre le potentiel de claquage dans le semiconducteur (de l'ordre de 20 V/µm). Ainsi, il convient que l'une des couches au voisinage de la jonction qui assure la tenue en tension soit relativement peu dopée pour que la zone de charge d'espace puisse s'y étendre assez largement.

Indépendamment, de la nécessité d'assurer une tenue en tension suffisante du composant quand des potentiels élevés sont appliqués à ses bornes, il se pose également des problèmes de courant de fuite. Pour diverses raisons, par exemple en raison d'une pollution des oxydes, il est possible que le substrat N 1 soit fortement déplété en surface sous une couche d'isolant supérieur 8. On peut même arriver à une inversion de population dans cette région. Il apparaît alors une région de canal assurant une continuité électrique entre la périphérie externe de la région P 6 et la périphérie interne du mur d'isolement 2. Pour éviter ces courants de fuite, il est connu d'utiliser une région dite d'arrêt de canal (stop-channel) constituée d'une zone 10 fortement dopée de type N (N⁺) à la surface du substrat 1 entre la périphérie externe de la région 6 et la périphérie interne du mur 2. Bien que cela n'apparaisse pas dans la vue en coupe, la zone 10 forme en fait un anneau qui s'étend sur toute la périphérie du composant concerné. Etant donné son fort niveau de dopage, l'anneau N⁺ 10 n'est pas susceptible d'être inversé et interrompt donc tout canal d'inversion susceptible de se former à la surface du composant. Pour favoriser l'équipotentialité de l'anneau d'arrêt de canal 10 et éviter qu'il se produise une déplétion localisée, il est classique de revêtir cet anneau diffusé 10 d'une métallisation (non représentée).

La figure 2A illustre quel peut être l'effet sur la répartition des équipotentielles d'une piste conductrice courant sur la surface supérieure du composant. Dans l'exemple représenté, la métallisation M2 est prolongée par une piste métallique L destinée par exemple à assurer une connexion entre la métallisation M2 et une métallisation d'un autre composant disposé dans le même substrat 1 à droite du mur d'isolement 2. Il convient de souligner, étant donné que cela n'est pas apparent dans la vue en coupe de la figure 2A, que la métallisation L correspond à une piste métallique relativement étroite devant la surface occupée par une métallisation de contact telle que la métallisation M2. Dans des composants de puissance, la piste métallique peut avoir une largeur de l'ordre de 10 à 100 µm. On a montré en figure 2A comment se déforment les équipotentielles E1L et E1H d'une part, et les équipotentielles E2L et E2H d'autre part, quand le composant se trouve polarisé respectivement en direct et en inverse.

Dans le cas où le composant se trouve polarisé en direct, l'équipotentielle E1L n'est pratiquement pas déformée tandis que l'équipotentielle E1H longe la piste mécanique en direction du mur d'isolement 2. Quand elle atteint ce mur d'isolement, il se produit un perçage (en anglais punch through). Ceci signifie que le composant devient passant alors que l'on souhaiterait qu'il puisse supporter la tension en restant bloqué. Ce perçage n'est pas destructeur mais entraîne un déclenchement prématuré d'un composant que l'on souhaiterait maintenir bloqué.

Lors d'une polarisation en inverse, c'est essentiellement l'équipotentielle E2L qui se déforme au niveau de la partie supérieure du composant. Alors, la zone de charge d'espace se réduit et le champ au niveau de la partie supérieure de la jonction entre le substrat 1 et le mur 2 augmente fortement. Il peut se produire un claquage (breakdown) de la jonction qui peut provoquer une destruction de celle-ci.

La figure 2B représente une variante de la figure 2A, dans le cas où il y a une région d'arrêt du canal 10. Lors d'une polarisation en direct, les équipotentielles E1 tendent à se déformer comme cela a été indiqué en relation avec la figure 2A. Toutefois, les équipotentielles hautes (EIH) et les équipotentielles intermédiaires viendront se resserrer dans la zone d'arrêt de canal 10 et il existe un risque élevé pour qu'il se produise un claquage dans cette zone. On voit donc que la présence d'une région d'arrêt de canal, qui évite les courants de fuite, dégrade la tenue en tension dans le cas considéré.

Le problème exposé ci-dessus qui se pose quand une piste de connexion court sur un composant haute tension est connu dans la technique et diverses solutions ont été proposées pour le résoudre.

Une solution évidente consiste à augmenter l'épaisseur de la couche isolante 8 au-dessus de laquelle circule la piste conductrice L de façon à réduire l'influence sur le semiconducteur du champ créé par cette piste. Toutefois, cette solution se heurte rapidement à des limites pratiques. En effet, il est difficile de déposer un isolant de qualité d'épaisseur supérieure à 6 µm, ce qui, pour de l'oxyde, conduit dans le meilleur des cas à une tenue en tension de l'ordre de 600 V.

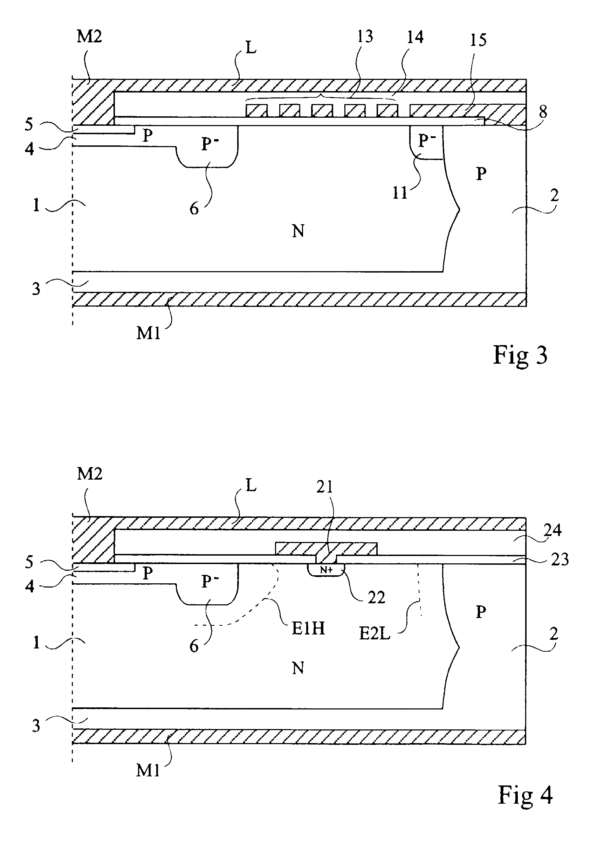

D'autres solutions utilisées pour des tensions supérieures à 600 V sont illustrées en figure 3. La figure 3 illustre plusieurs solutions qui sont habituellement utilisées alternativement.

Une première solution consiste à ajouter une région 11 faiblement dopée de type P, s'étendant le long de la périphérie interne du mur d'isolement 2 et en contact avec ce mur d'isolement. Ceci permet d'améliorer la tenue en tension en inverse (jonction entre le substrat 1 et le mur d'isolement 2).

Les autres solutions consistent à prévoir des plaques de champ.

Selon une deuxième solution, des plaques de champ flottantes 13 sont disposées au-dessus de la couche isolante 8, orthogonalement à la piste dont elles sont séparées par une couche isolante 14. Alors, si les plaques flottantes 13 débordent nettement transversalement par rapport à la piste, elles ne sont pas susceptibles d'être chargées capacitivement par celle-ci et sont couplées capacitivement au silicium. Elles prennent alors en charge les équipotentielles en les entraînant dans la zone d'oxyde. Toutefois, cette solution, basée sur le principe des capacités, dépend fortement de la qualité des oxydes et de leurs éventuelles contaminations. En outre, elle peut nécessiter l'emploi d'équipements de lithographie submicroniques dont on ne dispose pas nécessairement dans les technologies de fabrication des composants de puissance.

Selon une troisième solution, on utilise une plaque de champ 15 en contact avec le mur d'isolement 2 et s'étendant vers l'intérieur par rapport à ce mur d'isolement. Ce type de structure résout le problème de tenue en tension de la cathode car les équipotentielles sont prises en charge entre la plaque de champ et la piste avant d'atteindre la jonction d'anode. Toutefois, ceci implique un débordement de la plaque de champ par rapport au caisson, ce qui dégrade la tenue en tension de ce dernier. D'autre part, si l'anode est à la masse, le substrat à la haute tension et la piste proche de 0 volt (cas d'un substrat polarisé par la jonction en direct, cette dernière étant reliée à la cathode via une résistance diffusée) la cathode et l'anode sont alors simultanément bloquées et cette solution ne fonctionne pas.

Ainsi, les solutions de l'art antérieur présentent l'inconvénient ou bien d'exiger des technologies de mise en oeuvre complexes, ou bien d'être efficaces seulement pour une polarité particulière de la piste par rapport aux autres éléments, ou bien de nécessiter un accroissement de la surface de silicium utilisé.

La présente invention vise à résoudre le problème posé par la tenue en tension d'un composant de puissance en présence d'une piste d'interconnexion en évitant un ou plusieurs des inconvénients des structures de l'art antérieur.

Pour atteindre ces objets, la présente invention prévoit un composant haute tension formé dans une région d'un substrat de silicium d'un premier type de conductivité délimitée par un mur du deuxième type de conductivité, ayant une face inférieure comprenant une première région du deuxième type de conductivité reliée au mur, et une face supérieure comprenant au moins une deuxième région du deuxième type de conductivité, une tension élevée étant susceptible d'exister entre les première et deuxième régions et devant être supportée du côté de la face supérieure par la jonction entre la deuxième région et le substrat ou par la jonction entre le mur et le substrat, une piste conductrice pouvant être à un potentiel élevé s'étendant au-dessus du substrat entre la deuxième région et le mur. Ce composant comprend une troisième région du premier type de conductivité à fort niveau de dopage formée dans le substrat sous une portion de la piste sensiblement à mi-chemin entre la périphérie externe de la deuxième région et la périphérie interne du mur, cette troisième région étant contactée par une plaque de champ isolée de la piste, s'étendant dans le sens de la largeur au moins sensiblement sur la largeur de la piste et dans le sens de la longueur de part et d'autre de la troisième région en direction du mur et de la deuxième région.

Selon un mode de réalisation de la présente invention, la plaque de champ s'étend au-delà de la troisième région en direction du mur et en direction de la deuxième région sur une distance supérieur à 10 µm.

Selon un mode de réalisation de la présente invention, la périphérie externe de la deuxième région comporte un anneau du même type de conductivité à faible niveau de dopage.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1, 2A, 2B et 3 sont des vues en coupe schématiques d'une zone limite d'un composant haute tension selon l'art antérieur ; et
la figure 4 est une vue en coupe schématique d'une zone limite d'un composant haute tension selon la présente invention.

Dans les diverses figures, conformément à l'usage dans le domaine de la représentation des composants semiconducteurs, les diverses dimensions ne sont pas tracées à l'échelle et ont été arbitrairement tracées pour faciliter la lisibilité des figures et en améliorer l'intelligibilité. L'homme de l'art saura adapter les diverses épaisseurs et niveaux de dopage en fonction des règles habituelles de fabrication des composants semiconducteurs de puissance.

La figure 4 représente la même région frontalière d'un composant haute tension que celle représentée en figure 1.

Selon la présente invention, il est prévu une plaque de champ 21 disposée au-dessus du substrat 1 entre la périphérie externe de la jonction de type P (6-1) qui tient la tension en direct et la périphérie interne du mur d'isolement qui tient la tension en inverse. La plaque de champ 21 est formée sur une couche isolante 23 et est séparée de la métallisation M2 par une couche isolante 24. Cette plaque de champ s'étend entre la périphérie externe de la région 6 et la périphérie interne du mur d'isolement 2 sensiblement jusqu'à l'extension normale de la zone de charge d'espace (E1H, E2L) qui se produirait pour la tenue en tension visée en absence de la piste L. La plaque de champ 21 est en contact, sensiblement dans sa partie centrale dans la direction longitudinale avec le substrat 1 par l'intermédiaire d'une région de prise de contact plus fortement dopée de type N⁺ 22. Bien que cela ne soit pas apparent sur la vue en coupe, on notera que la région de contact 22 a sensiblement la largeur de la piste L et ne constitue pas un anneau périphérique comme dans le cas de l'anneau d'arrêt de canal 10 décrit en relation avec la figure 1. La plaque de champ a quant à elle une largeur de préférence légèrement supérieure à celle de la piste.

On constate qu'avec une telle plaque de champ, la répartition des équipotentielles est peu déformée par rapport à ce qu'elle est en l'absence de la piste L. Quand le composant est bloqué, l'équipotentielle E1H, qui tend comme cela a été décrit précédemment à longer la piste L, ne peut pas aller jusqu'à la zone de contact 22, mais remonte vers la couche d'isolant supérieure qui assure une tenue en tension élevée entre la plaque de champ et la piste L avant d'atteindre une quelconque jonction, évitant ainsi un perçage ou un claquage prématuré. On notera que cette solution est également efficace quand la piste métallique est connectée à l'anode ainsi que quand les deux jonctions sont simultanément bloquées.

La plaque de champ 21 peut être en tout matériau conducteur usuel dans le domaine de la fabrication des composants semiconducteurs : silicium polycristallin dopé, siliciure métallique, métal, alliage métallique...

Si on désigne par E1 (en µm) l'épaisseur de la couche d'oxyde 23 sous la plaque de champ, par E2 (en µm) l'épaisseur de la couche d'oxyde 24 formée au-dessus de la plaque de champ et par d (en µm) l'extension latérale de la plaque de champ au delà de la région 22, on a obtenu pour la tension de claquage V_{BR} (en volts), les résultats illustrés par le tableau I.

**TABLEAU I**

| **E1** | **E2** | **d** | **V**_{**BR**} |
|---|---|---|---|
| 2,7 | 3 | 2 | 470 |
| 2,7 | 3 | 14 | 670 |
| 2,7 | 3 | 30 | 680 |
| 2,7 | 3 | 50 | 680 |

On voit que, dès que le débordement d atteint une valeur suffisante, supérieure à 10 µm dans l'exemple considéré, la tension de claquage est nettement augmentée et passe de moins de 500 V à près de 700 V. Bien entendu, cette tension de claquage augmente si les épaisseurs d'isolant augmentent.

La plaque de champ selon l'invention peut s'étendre, comme on l'a indiqué ci-dessus, seulement sensiblement sur la largeur de la piste. Dans le cas où il existe une région périphérique d'arrêt de canal, elle pourra s'étendre sur toute la périphérie de cette région d'arrêt de canal.

## Revendications

1. Composant de puissance formé dans une région (1) d'un substrat de silicium d'un premier type de conductivité délimitée par un mur (2) du deuxième type de conductivité, ayant une face inférieure comprenant une première région (3) du deuxième type de conductivité reliée au mur (2), et une face supérieure comprenant au moins une deuxième région (4) du deuxième type de conductivité, une tension élevée étant susceptible d'exister entre les première et deuxième régions et devant être supportée du côté de la face supérieure par la jonction entre la deuxième région et le substrat ou par la jonction entre le mur et le substrat, une piste conductrice (L) pouvant être à un potentiel élevé s'étendant au-dessus du substrat entre la deuxième région (4) et le mur (2),
caractérisé en ce qu'il comprend une troisième région (22) du premier type de conductivité à fort niveau de dopage formée dans le substrat sous une portion de ladite piste sensiblement à mi-chemin entre la périphérie externe de la deuxième région et la périphérie interne du mur, cette troisième région étant contactée par une plaque de champ (21) isolée de ladite piste, s'étendant dans le sens de la largeur au moins sensiblement sur la largeur de la piste et dans le sens de la longueur de part et d'autre de la troisième région en direction du mur et de la deuxième région.

2. Composant selon la revendication 1, dans lequel ladite plaque de champ (21) s'étend au-delà de la troisième région (22) en direction du mur et en direction de la deuxième région sur une distance supérieur à 10 µm.

3. Composant selon la revendication 1, dans lequel la périphérie externe de la deuxième région (4) comporte un anneau (6) du même type de conductivité à faible niveau de dopage.
